(19) **Europäisches Patentamt / European Patent Office / Office européen des brevets**

(11) **EP 1 481 427 B1**

(12) **EUROPEAN PATENT SPECIFICATION**

(45) Date of publication and mention
of the grant of the patent:
**05.08.2009 Bulletin 2009/32**

(51) Int Cl.:
*H01L 31/18* (2006.01)   *H01L 31/02* (2006.01)
*H01L 31/0224* (2006.01)

(21) Application number: **03706601.6**

(22) Date of filing: **03.03.2003**

(86) International application number:
**PCT/EP2003/002218**

(87) International publication number:
**WO 2003/075351 (12.09.2003 Gazette 2003/37)**

(54) **PROCESS FOR MANUFACTURING A SOLAR CELL UNIT USING A TEMPORARY SUBSTRATE**

HERSTELLUNGSVERFAHREN EINER SOLARZELLE UNTER VERWENDUNG EINES VORÜBERGEHENDEN SUBSTRATS

PROCEDE DE FABRICATION D'UNE UNITE DE CELLULE SOLAIRE A L'AIDE D'UN SUBSTRAT PROVISOIRE

(84) Designated Contracting States:
**AT BE BG CH CY CZ DE DK EE ES FI FR GB GR HU IE IT LI LU MC NL PT RO SE SI SK TR**

(30) Priority: **05.03.2002 EP 02075893**
**20.03.2002 US 365841 P**

(43) Date of publication of application:
**01.12.2004 Bulletin 2004/49**

(73) Proprietor: **Helianthos B.V.**
**6824 BM Arnhem (NL)**

(72) Inventors:
• **MIDDELMAN, Erik**
**NL-6815 EV Arnhem (NL)**

• **PETERS, Paulus, Marinus, Gezina, Maria**
**NL-6922 AJ Duiven (NL)**
• **SCHROPP, Rudolf, Emmanuel, Isidore**
**NL-3972 GE Driebergen (NL)**

(74) Representative: **Beetz, Tom et al**
**De Vries & Metman**
**Overschiestraat 180**
**1062 XK Amsterdam (NL)**

(56) References cited:
**WO-A-01/47020          US-A- 4 507 181**
**US-A- 4 771 017          US-B1- 6 184 057**

## Description

The invention pertains to a process for manufacturing a solar cell unit using a temporary substrate. The invention also pertains to the solar cell unit thus obtained.

Solar cell units, also known as photovoltaic units or photovoltaic foils, generally comprise a carrier and a photovoltaic (PV) layer composed of a semiconductor material provided between a front electrode comprising a transparent conductive oxide (TCO) (at the front of the foil) and a back electrode (at the back of the foil). The front electrode is transparent, enabling incident light to reach the semiconductor material, where the incident radiation is converted into electric energy. In this way light can be used to generate electric current, which offers an interesting alternative to, say, fossil fuels or nuclear power.

WO 98/13882 and WO99/49483 describe a method for manufacturing a photovoltaic foil comprising the steps of providing a temporary substrate, applying the transparent conductive oxide, applying the photovoltaic layers, applying the back electrode layer, applying the carrier, removing the temporary substrate, and, preferably, applying a transparent protective top coat on the side of the transparent conductor layer. This method enables the roll-to-roll manufacture of a photovoltaic foil or device, while at the same time making it possible to use any desired transparent conductor material and deposition process, without jeopardizing the current-generating action of the PV layers. WO 01/78156 and WO 01/47020 describe variations on this process.

It is indicated in the above publications that it is preferred to use a metallic temporary substrate because such materials generally will be able to withstand the highest temperatures during further processing, suffer little from evaporation, and can be removed relatively easily using known etching techniques. Another reason to choose metal, notably aluminium or copper, is that the PV foil should eventually contain "side" electrodes (which form a contact for connection to any auxiliary apparatus or net, i.e., to actually use the PV foil as a source of power). By allowing part of the temporary substrate to remain in place (e.g., as side edges or stripes) these contacts do not need to be applied separately. Document US-B-6,184,057 discloses a method to manufacture a solar cell that makes use of a temporary substrate.

In order to improve the collection of current from the solar cell unit, solar cell units frequently are provided with a current collection grid. In the case of solar cell foil units the grid is applied on the front electrode and/or, less commonly, on the back electrode if the back electrode is made of a comparatively poorly conductive TCO to obtain a (semi)transparent solar cell unit. The grid is a pattern of lines of a conductive material which is applied in such a way as to enable easy collection of the current generated in the photovoltaic layer and flowing through the electrode.

Various ways of applying grids are known in the art. It is known, for example, to apply a grid via a printing technique, generally using a paste containing silver particles. The disadvantage of using this type of paste is that its conductivity is relatively low. It is possible to increase the conductivity by firing the paste, but this introduces an additional processing step. Also, the firing generally has a detrimental effect on the properties of the solar cell unit, in particular on those of the photovoltaic layer and optional polymer layers, while the resulting conductivity of the grid still leaves something to be desired.

It is also known in the art to apply the grid by depositing molten metal. Although this results in a grid with a good conductivity, the high temperature of the molten metal usually detrimentally affects the properties of the TCO layer, in particular of the photovoltaic layer. Also, a number of additional steps are required to prepare the surface for metals deposition.

Recent developments concern the deposition at relatively low temperatures of metallic layers that can solidify spontaneously after their application. At present, however, these methods do not yield photovoltaic devices of acceptable quality. WO 93/00711 describes the formation of a current collection grid on top of the layer of transparent conductive material by securing an electrically conductive foil thereto by way of an electrically conductive adhesive. Subsequently, a portion of the conductive foil is removed via an etching technique. One problem associated with this process resides in the conductive adhesive, which should also be removed in the locations where the conductive foil has been removed. This may, e.g., be done by way of a solvent, but this incurs the risk that the solvent will also dissolve the adhesive bonding the current collection grid to the front electrode. A further problem associated with this process is the conductivity of the connection between the current collection grid and the TCO layer via the adhesive.

A problem associated with all of the above ways of applying a grid onto a solar cell unit is the adherence of the grid to the surface of the solar cell unit, which is in need of improvement.

There is therefore need for a process for manufacturing a solar cell unit comprising a grid, wherein the grid has a good conductivity and a good adherence to the TCO layer, and can be obtained by a simple and well-controlled process which does not result in damaging the properties of the solar cell foil, in particular the TCO layer.

It has now been found that these problems can be solved by manufacturing the solar cell unit using a temporary substrate, with part of the conductive temporary substrate being maintained as the current collection grid, which for the purposes of the present specification also includes the busbars.

The present invention therefore pertains; to a process for manufacturing a solar cell unit provided with a current collection grid comprising the steps of

    a. providing a foil of an etchable conductive temporary substrate with a thickness of up to 500 microns

b. applying a layer of a transparent conductive oxide (TCO) onto the temporary substrate

c. applying a photovoltaic layer onto the TCO layer

d. applying a back electrode layer

e. applying a permanent carrier

f. in any one of the preceding steps providing an "etch resist" on the temporary substrate in a pattern which after removal of the portion of the temporary substrate which is not covered with etch resist will result in the formation of a current collection grid

g. selectively removing the temporary substrate where it is not covered with etch resist, to form a solar cell provided with a current collection grid.

In the context of the present specification, the term etching is intended to mean removing by chemical means, e.g., dissolution. An etchable substrate is a substrate which can be removed by chemical means; an etch resist is a material which can resist the conditions applied during the removal of the temporary substrate.

Because in the process according to the invention the TCO layer is, in effect, deposited on what later will become the current collection grid, it can be ensured that the ohmic contact between the TCO and the current collection grid will be good. Due to the fact that the TCO layer is grown on the temporary substrate, it can be ensured that the adherence between the TCO layer and the grid formed from the temporary substrate is good. Because the temporary substrate is a metallic substrate, the conductivity of the grid itself will also be good. Additionally, taking into account that the use of a temporary substrate always necessitates its removal, generally by way of an etching step, the process according to the invention only adds one simple step, the application of the etch resist, to the process known from WO 98/13882 or WO99/4948 The application of the etch resist can easily be incorporated into the preparation process of the above references, especially if this is carried out via a roll-to-roll process. This integration makes it possible to position the grid in an exact and reproducible manner, especially since etch resist is a material which is easy to apply, much easier than, e.g., molten metal strips.

The etch resist can be any material which can be applied to the temporary substrate in the form of the current collection grid and which will protect the temporary substrate from the action of the etchant. The etch resist may be temporary, that is, it may be removed at some further stage of the process. Alternatively, the etch resist may be permanent. The use of a permanent etch resist is preferred. There are various reasons for this preference. In the first place, the use of a permanent etch resist obviates the need for an etch resist removal step. Further, the etch resist will protect the grid from outside influences and add to the dielectric breakdown strength of the encapsulated module.

A particularly preferred embodiment of the process of the invention is one in which the etch resist is a permanent etch resist the color of which has been selected such that the current collection grid has a color which matches that of the energy-generating part of the solar cell unit or contrasts with it.

The color difference between the energy-generating part of the solar cell unit and a colored grid can be expressed by way of the dEab, which is defined as follows:

$$dEab = (dL^2 + da^2 + db^2)^{1/2}$$

wherein dL, da, and db are the differences in brightness, blueness, and redness, respectively, between the parts provided with coloring material and the energy-generating parts of the solar cell unit. The L, a, and b values can be determined in accordance with the CIELAB procedure using a D65 light source. If the color of the grid is to match that of the solar cell unit, the dEab generally is below about 5, preferably below about 2, more preferably, below about 0.3. In that case one can speak of the use of a camouflage color. If the color of the grid is selected to contrast with that of the energy-generating part of the solar cell unit, the dEab value generally is above about 10, preferably above about 12, more preferably between about 20 and 100. If more than one color is used, generally at least one of these colors will satisfy the above requirements for the dEab value.

The use of a combination of a distinguishing color and a camouflage color makes it possible to decorate the solar cell unit with colored designs on a homogeneous background. Examples of envisaged designs are patterns, letters, figures, stripes, rectangles, and squares. In this embodiment, generally 10-90% of the grid is provided with a distinguishing color, while 90-10% of the grid is provided with a camouflage color.

It is noted that it has been described in the art to provide a color coating on the grid of a solar cell unit. Reference is made to EP 0 986 109 and international application WO 02/21602. However, these references do not describe applying a color coating as etch resist to obtain a colored high-quality metallic current collection grid via a temporary substrate.

Incidentally, although less preferred, it is within the scope of the present invention to use a temporary etch resist in the manufacturing of the grid, followed by removing the temporary etch resist and providing the grid with a colored material, e.g., as described in international application No. WO 02/21602.

The application of the etch resist onto the temporary substrate can be carried out at any stage in the process according to the invention. It can, e.g., be applied before the beginning of the process, that is, before the application of the TCO onto the other side of the temporary substrate. It can be applied at any intermediate stage, and it can be applied at the end of the process, that is, after the application of the back electrode or, where applicable, the permanent carrier, and just before removal of the temporary substrate by etching. The latter option is preferred, because it prevents the etch resist pattern being damaged during the preceding parts of the process. It also prevents the presence of the etch resist pattern on the "back" of the temporary substrate from interfering with the other processing steps. In the preferred roll-to-roll embodiment of the process according to the invention both may happen if the temporary substrate provided with a pattern in an etch resist on the back is led over one or more rolls.

It may be that the temporary substrate is thicker than is desired for the current collection grid to be formed. In that case, one can first etch part of the temporary substrate, then apply the etch resist in the pattern of the current collection grid, and subsequently remove the unprotected portion of the etch resist. It is preferred, however, in such a case to first apply a temporary etch resist in the pattern of the current collection grid, followed by selective removal of the temporary substrate where it is not protected by an etch resist. Then, the temporary etch resist is removed and a further etching step is performed to reduce the thickness of the current collection grid.

In a preferred embodiment of the process according to the invention, the temporary substrate is flexible, a flexible permanent carrier is applied, and the process is carried out by way of a roll-to-roll process.

A particular advantage of the process according to the invention is that a grid is obtained with an attractive cross-sectional shape. More in particular, the process according to the invention makes it possible to prepare solar cell sheets provided with a grid wherein the ratio between the grid height and the grid width (determined over the broadest part of the cross-section of the grid) is at least 0.1, preferably at least 0.2, more preferably at least 0.3. The selection of a grid which in comparison with prior art grids is relatively high as compared to its width has the consequence that, due to the small width, the amount of surface area covered by the grid is relatively low, leading to a higher energy yield, while the relatively high height ensures that the current connecting properties of the grid are still good. A grid with this height to width ratio cannot be obtained by conventional methods such as metal sputtering etc.

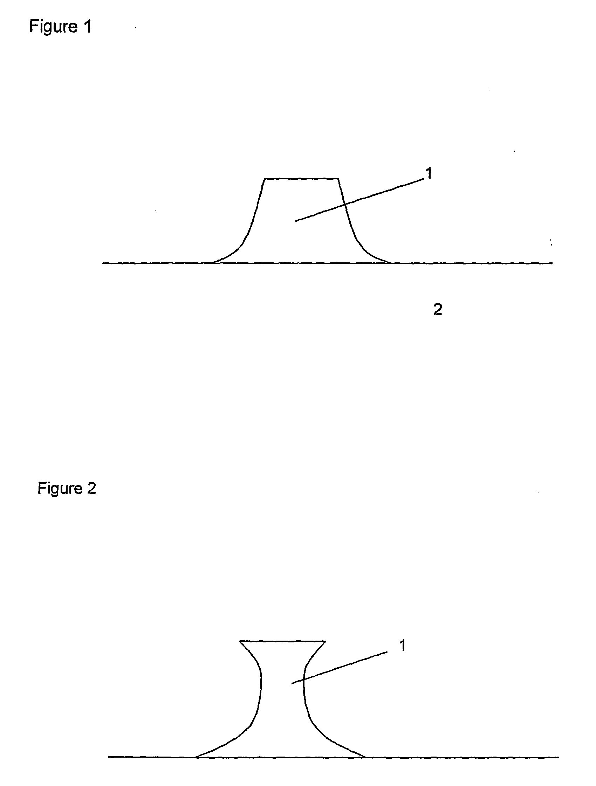

Another feature of the cross-sectional shape of the grid obtained by the process of the present invention is that the grid has its largest width at the interface with the TCO layer and then tapers off to its smallest cross-section in a curved fashion, e.g, as illustrated in figure 1, wherein 1 refers to the grid and 2 to the solar cell unit provided with the grid. This shape has a number of specific advantages. In the first place, this shape leads to the combination of a relatively high contact area between the grid and the TCO, which leads to less contact resistance losses, and less shadow effect next to the grid. Further, the grid has an increased resistance to delamination because its specific sloping shape ensures a better force dispersion. Finally, the sloping shape makes it easier to apply an encapsulant over the solar cell unit without gas inclusion next to the grid.

For good order's sake it is noted that the smallest width of the cross-section of the grid is not necessarily located at the top of the grid. Since the etchant may have a preference for the sideways direction, it may be that the width of the cross-section of the grid is smallest somewhere halfway, as illustrated in figure 2, wherein 1 refers to the grid and 2 to the solar cell unit provided with the grid. Nevertheless, it is preferred for the grid to have its smallest width of the cross-section at the top of the grid. The ratio between the width of the cross-section of the grid at its smallest point and the width of the cross-section at the interface with the TCO generally is between 0.1:1 and 0.9:1, preferably between 0.2:1 and 0.7:1, more preferably between 0.4 and 0.6:1.

For good order's sake it is noted that it is within the scope of the present invention to manufacture part of the grid via the temporary substrate and apply another part in a different manner. For example, it can be envisaged that the finer part of the grid is obtained from the temporary substrate while the coarser part of the grid, e.g., the busbars, is applied in a different manner, e.g., by the application of conductive tape. It is preferred for the solar cell unit obtained by the process according to the invention to have at least 50% of its grid surface resulting from the temporary substrate, more preferably at least 70%, still more preferably at least 90%, most preferably at least 95%.

### The temporary substrate

The temporary substrate has to satisfy a number of conditions. It has to be sufficiently conductive to be able to serve as a base material for a current collection grid. It has to be sufficiently heat-resistant to be able to endure the conditions prevailing during the manufacture of the solar cell unit, more particularly during the deposition of the TCO and the PV layer. It has to be strong enough to be able to carry the solar cell unit during its manufacture. It has to be easy to remove from the TCO layer without damaging the latter. The person skilled in the art will be able to select a suitable temporary substrate within these guidelines.

The temporary substrate employed in the process according to the invention preferably is a foil of a metal or a metal alloy. The principal reasons for this are that such foils exhibit good conductivity, generally are able to withstand high processing temperatures, are slow to evaporate, and are comparatively easy to remove using known etching techniques. Another reason to choose a metal foil, more particularly aluminium or copper, is that in the end the solar cell unit has to be provided with edge electrodes which have to connect the solar cell unit to an apparatus or the electricity grid. Remaining pieces of temporary substrate may be used to this end, as a result of which there is no need for separate provision of the edge electrodes.

Suitable metals include steel, aluminium, copper, iron, nickel, silver, zinc, molybdenum, chromium, and alloys or multi-layers thereof. For economic reasons among others it is preferred to employ Fe, Al, Cu, or alloys thereof. Given their performance (and taking into account the matter of cost) aluminium, iron, and copper are preferred most.

Suitable etchants and techniques for removing metals are known, and while they differ per metal, the skilled person will be able to select the appropriate ones. Preferred etchants include acids (both Lewis and Brønstedt acids). Thus in the case of copper it is preferred to use $FeCl_3$, nitric acid or sulphuric acid. Suitable etchants for aluminium are, e.g., NaOH, KOH, and mixtures of phosphoric acid and nitric acid.

If copper, optionally prepared by way of electrodeposition, is used as temporary substrate, it is preferred to provide the copper, optionally via electrodeposition, with a non-reducing diffusion barrier layer, e.g., an anti-corrosion layer, more particularly zinc oxide. This is because copper may have the tendency to diffuse through the TCO layer in the PV layer. It is also possible to select a TCO capable of preventing such diffusion, e.g., $SnO_2$ or ZnO. The anti-diffusion layers can be applied by means of for instance electrodeposition, or via Physical Vapor Deposition (PVD) or via Chemical Vapor Deposition (CVD). The anti-diffusion layer generally is removed from the TCO together with the temporary substrate, but is maintained at the location of the grid. Obviously, if a layer such as an anti-diffusion layer and/or a buffer layer is present between the TCO layer and the grid, its properties should be such that it does not interfere with the transport of current from the TCO to the grid. Thus, any intermediate layer between the grid and the TCO layer should be conductive.

For ease of removal, the temporary substrate preferably is as thin as possible. On the other hand, a certain thickness is required to ensure that the grid obtained from the temporary substrate can collect sufficient current. Further, its thickness has to be such that other layers can be provided on it and it has to be able to hold these together, but this generally does not require it to be more than 500 $\mu$m (0.5 mm) thick. The thickness preferably is in the range of 1 to 200 $\mu$m (0.2 mm). Depending on the modulus of elasticity, the minimum thickness for a large number of materials will be 5 $\mu$m. Accordingly, a thickness of 5-150 $\mu$m, more particularly 10-100 $\mu$m, is preferred.

Incidentally, by proper selection of the width of the etch resist in combination with the thickness of the temporary substrate, the current collection properties of the grid can be regulated. By varying the width of the etch resist over the surface of the solar cell unit, the current collection properties of the grid can be adapted to the amount of current generated at a specific location.

The TCO layer

Examples of suitable transparent conductive oxides (TCOs) are indium tin oxide, zinc oxide, zinc oxide doped with aluminium, fluorine, gallium or boron, cadmium sulphide, cadmium oxide, tin oxide, and, most preferably, F-doped $SnO_2$. Said last-mentioned transparent electrode material is preferred, because it can form a desired crystalline surface with a columnar light scattering texture when it is applied at a temperature above 400°C, preferably in the range of 500 to 600°C, or after-treated at said temperature. It is precisely in the case of this TCO material that the use of a temporary substrate capable of withstanding such a high temperature is extremely attractive. In addition, the material is resistant to most etchants and has a better resistance to chemicals than the much-used indium tin oxide. Also, it is far less costly.

The TCO can be applied by means of methods known in the field, e.g., by means of Metal Organic Chemical Vapor Deposition (MOCVD), sputtering, Atmospheric Pressure Chemical Vapor Deposition (APCVD), PECVD, spray pyrolysis, evaporation (physical vapor deposition), electrodeposition, electroless plating, screen printing, sol-gel processes, etc. or combinations of these processes. It is preferred to apply and after-treat the TCO layer at a temperature above 250°C, preferably above 400°C, more preferably between 450 and 600°C, so that a TCO layer of the desired composition, properties and/or texture can be obtained.

The buffer layer

If so desired, a buffer layer may be present between the TCO layer and the photovoltaic layer. The buffer layer is intended to protect the TCO layer from the conditions prevailing during the deposition of the PV layer. The nature of the buffer layer will depend on the nature of the PV layer. Suitable buffer layers for the various PV layers are known in the art. For cadmium telluride CdS, In(OH,S) and Zn(OH,S) may be mentioned. If in the present specification mention is made of depositing the PV layer on the TCO, a buffer layer may or may not be present on said TCO.

The photovoltaic (PV) layer

After application of the TCO layer the PV layer can be applied in an appropriate manner. It should be noted here that in the present description the term " PV layer or "photovoltaic layer" comprises the entire system of layers needed to absorb the light and convert it into electricity. Suitable layer configurations are known, as are the methods for applying them. For the common general knowledge in this field reference may be had to Yukinoro Kuwano, "Photovoltaic Cells," Ullmann's Encyclopedia, Vol.A20 (1992), 161 and " Solar Technology," Ullmann's Encyclopedia, Vol.A24 (1993), 369.

Various thin film semiconductor materials can be used in manufacturing the PV layers. Examples are amorphous silicon (a-Si:H), microcrystalline silicon, polycrystalline amorphous silicon carbide (a-SiC) and a-SiC:H, amorphous silicon-germanium (a-SiGe), and a-SiGe:H. In addition, the PV layer in the solar cell unit according to the invention may comprise CIS (copper indium diselenide, $CuInSe_2$), cadmium telluride (CdTe), CIGSS (Cu(In,Ga)(Se,S)), $Cu(In,Ga)Se_2$, ZnSe/CIS, ZnO/CIS, and/or Mo/CIS/CdS/ZnO, and dye sensitised solar cells.

The PV layer preferably is an amorphous silicon layer when the TCO comprises a fluorine-doped tin oxide. In that case the PV layer will generally comprise a set, or a plurality of sets, of p-doped, intrinsic, and n-doped amorphous silicon layers, with the p-doped layers being situated on the side receiving the incident light.

In the a-Si-H embodiment the PV layer will at least comprise a p-doped amorphous silicon layer (Si-p), an intrinsic amorphous silicon layer (Si-i), and an n-doped amorphous silicon layer (Si-n). It may be that onto the first set of p-i-n layers a second and further p-i-n layers are applied. Also, a plurality of repetitive p-i-n ("pinpinpin" or "pinpinpinpin") layers can be applied consecutively. By stacking a plurality of p-i-n layers, the voltage per cell is raised and the stability of the system is enhanced. Light-induced degradation, the so-called Staebler-Wronski effect, is diminished. Furthermore, the spectral response can be optimized by choosing different band-gap materials in the various layers, mainly the i-layers, and particularly within the i-layers. The overall thickness of the PV layer, more particularly of all the a-Si layers together, will generally be of the order of 100 to 2,000 nm, more typically about 200 to 600 nm, and preferably about 300 to 500 nm.

## The back electrode

The back electrode in the thin film solar cell sheet according to the invention preferably serves both as reflector and as electrode. Generally, the back electrode will have a thickness of about 50 to 500 nm, and it may comprise any suitable material having light reflecting properties, preferably aluminium, silver, or a combination of layers of both, and making good ohmic contact with the subjacent semiconductor layer. Preferably, it is possible to apply the metal layers at a comparatively low temperature, say less than 250°C, by means of, e.g., electrodeposition, *(in vacuo)* physical vapor deposition or sputtering. In the case of silver, it is preferred to first apply an adhesion promoter layer. $TiO_2$, TiN, ZnO, and chromium oxide are examples of suitable materials for an adhesion promoter layer and have the advantage of also possessing reflecting properties when applied in a suitable thickness, e.g., of 50-100 nm. The required back electrode may be either transparent or opaque.

## The permanent carrier

Although it is not essential to the process according to the invention, as a rule it is preferred to provide the solar cell unit with a permanent carrier. For, otherwise the unit will be so thin that its fragility makes for difficult handling. When employed, the permanent carrier is applied on the back electrode.

Suitable carrier layer materials include films of commercially available polymers, such as polyethylene terephthalate, poly(ethylene 2,6-naphthalene dicarboxylate), polycarbonate, polyvinyl chloride, PVDF, PVDC, PPS, PES, PEEK, PEI or films of polymer having very good properties such as aramid or polyimide films, but also, for example, metal foils onto which an insulating (dielectric) surface layer may have been applied, or compositions of plastics and reinforcing fibres and fillers. Polymeric" co-extruded" films provided with a thermoplastic adhesive layer having a softening point below that of the substrate itself are preferred. If so desired, the co-extruded film may be provided with an anti-diffusion layer of, e.g., polyester (PET), copolyester or aluminium. The thickness of the carrier preferably is 50 $\mu$m to 10 mm. Preferred ranges are 75 $\mu$m to 3 mm and 100 $\mu$m to 300 $\mu$m. The bending stiffness of the carrier, defined within the context of this description as the product of the modulus of elasticity E in $N/mm^2$ and the thickness t to the power of three in mm ($E \times t^3$), preferably is higher than $16 \times 10^{-2}$ Nmm and will generally be lower than $15 \times 10^6$ Nmm.

The carrier may comprise a structure as required for its final use. Thus the substrate may comprise tiles, roofing sheets and elements, façade elements, car and caravan roofs, etc. In general, however, preference is given to the carrier being flexible. In that case a roll of solar cell foil is obtained which is ready for use and where sheets of the desired power and voltage can be cut off the roll. These can then be incorporated into (hybrid) roof elements or be applied onto tiles, roofing sheets, car and caravan roofs, etc., as desired.

If so desired, a top coat or surface layer may be provided on the TCO side of the solar cell to protect the TCO from outside influences. Generally, the surface layer will be a polymer sheet (with cavities if so desired) or a polymer film. The surface layer is required to have a high transmission and for instance comprises the following materials: (per)fluorinated polymers, polycarbonate, poly(methylmethacrylate), PET, PEN or any clear coating available, such as the ones used in the car industry. If so desired, an additional anti-reflection or anti-fouling layer may be provided. Alternatively, if so desired, the entire solar cell may be incorporated into such an encapsulant.

## The etch resist

The etch resist can be any material which can be applied to the temporary substrate in the form of the current collection grid and which will protect the temporary substrate from the action of the etchant. The skilled person can select suitable material by routine testing. Suitable etch resists include thermoplastic and thermoset polyurethanes and polyimides, thermoset polymers such as EP, UP, VE, SI, (epoxy)resins, and acrylates, and thermoplastic polymers such as PVC, PI, fluorpolymers, etc. The etch resist generally includes additives such as photoinitiators or other hardeners, fillers, plastifiers, etc. The etch resist may be temporary, that is, it may be removed at some further stage of the process. Alternatively, and preferably, the etch resist may be permanent.

The etch resist is suitably applied by vaporising or printing/writing. Preferably, the etch resist is applied by means of a printing process known as such. Suitable printing processes include silk screening, roto screen printing, ink-jet processes, flexgravure, direct extrusion, etc. The color of the etch resist can be regulated by the incorporation of suitable pigments or dyes known to the skilled person. Especially for permanent etch resists, the presence of pigments and UV stabilisers may be preferred.

## Claims

1. A process for manufacturing a solar cell unit provided with a current collection grid, comprising the steps of

   a. providing a foil of an etchable conductive temporary substrate with a thickness of up to 500 microns

   b. applying a layer of a transparent conductive oxide (TCO) onto the temporary substrate

   c. applying a photovoltaic layer onto the TCO layer

   d. applying a back electrode layer

   e. applying a permanent carrier

   f. in any one of the preceding steps providing an etch resist on the temporary substrate in a pattern which, after removal of the portion of the temporary substrate which is not covered with etch resist, will result in the formation of a current collection grid

   g. selectively removing the temporary substrate where it is not covered with etch resist, to form a solar cell unit provided with a current collection grid.

2. The process of claim 1 wherein the pattern forming a current collection grid is provided after the application of the back electrode and, where applicable, the permanent carrier.

3. The process of claim 1 or 2 wherein the etch resist is a permanent etch resist.

4. The process of claim 3 wherein the permanent etch resist is provided with a color to distinguish the grid from the solar cell unit and/or to camouflage the grid on the solar cell unit.

5. The process of any one of the preceding claims wherein the temporary substrate is flexible, wherein a flexible permanent carrier is applied, and wherein the process is carried out by way of a roll-to-roll process.

## Patentansprüche

1. Verfahren zur Herstellung einer Solarzelleneinheit, die mit einem Stromsammelnetz versehen ist, das die Schritte umfasst:

   a) Bereitstellen einer Folie eines ätzbaren leitfähigen temporären Substrats mit einer Dicke von bis zu 500 μm;
   b) Aufbringen einer Schicht eines transparenten leitfähigen Oxids (TCO) auf das temporäre Substrat;
   c) Aufbringen einer fotovoltaischen Schicht auf die TCO-Schicht;
   d) Aufbringen einer Rückelektrodenschicht;
   e) Aufbringen eines permanenten Trägers;
   f) in jedem der vorhergehenden Schritte das Vorsehen eines Ätzresists auf dem temporären Substrat in einem Muster, das nach Entfernung des Teils des temporären Substrats, der nicht mit Ätzresist bedeckt ist, zur Bildung eines Stromsammelnetzes führt;
   g) selektives Entfernen des temporären Substrats, wo es nicht mit Ätzresist bedeckt ist, um eine mit einem Stromsarmmelnetz versehene Solarzelleneinheit zu bilden.

2. Verfahren, nach Anspruch 1, bei dem das Muster, das ein Stromsammelnetz bildet, nach der Aufbringung der Rückelektrode und gegebenenfalls des permanenten Trägers bereitgestellt wird.

3. Verfahren nach Anspruch 1 oder 2, bei dem der Ätzresist ein permanenter Resist ist.

4. Verfahren von Anspruch 3, bei dem der permanente Ätzresist mit einer Farbe versehen ist, um das Netz von der Solarzelleneinheit zu unterscheiden und/ oder das Netz auf der Solarzelleneinheit zu tarnen.

5. Verfahren gemäß mindestens einem der vorhergehenden Ansprüche, bei dem das temporäre Substrat flexibel ist, ein flexibler permanenter Träger aufgebracht wird und das Verfahren mit Hilfe eines Walzen-zu-Walsen-Verfahrens durchgeführt wird.

**Revendications**

1. Procédé de fabrication d'une unité de cellule solaire pourvue d'une grille de collecte de courant, comprenant les étapes suivantes :

   a. fournir une feuille de substrat provisoire conducteur pouvant être gravé ayant une épaisseur allant jusqu'à 500 microns
   b. appliquer une couche d'oxyde conducteur transparent (TCO) sur le substrat provisoire
   c. appliquer une couche photovoltaïque sur la couche TCO
   d. appliquer une couche d'électrode arrière
   e. appliquer un support permanent
   f. dans l'une quelconque des étapes précédentes, fournir une réserve de gravure sur le substrat provisoire ayant un motif qui, après l'élimination de la partie du substrat provisoire qui n'est pas recouverte par à réserve de gravure, aboutira à la formation d'une grille de collecte de courant
   g. éliminer sélectivement le substrat provisoire où il n'est pas recouvert par la réserve de gravure pour former une unité de cellule solaire pourvue d'une grille de collecte de courant.

2. Procédé selon la revendication 1, dans lequel le motif formant une grille de collecte de courant est fourni après l'application de l'électrode arrière et, quand cela est possible, du support permanent.

3. Procédé selon la revendication 1 ou 2, dans lequel la réserve de gravure est une réserve de gravure permanente.

4. Procédé selon la revendication 3, dans lequel la réserve de gravure permanente est fournie avec une couleur pour faire la distinction entre la grille et l'unité de cellule solaire et/ou pour camoufler la grille sur l'unité de cellule solaire.

5. Procédé selon l'une quelconque des revendications précédentes, dans lequel le substrat provisoire est flexible, dans lequel un support permanent flexible est appliqué et dans lequel le procédé est réalisé grâce à un procédé d'enduction au rouleau.

Figure 1

Figure 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9813882 A
- WO 9949483 A
- WO 0178156 A
- WO 0147020 A
- US 6184057 B
- WO 9300711 A
- WO 994948 A
- EP 0986109 A
- WO 0221602 A

**Non-patent literature cited in the description**

- Photovoltaic Cells. **Yukinoro Kuwano.** Ullmann's Encyclopedia. 1992, vol. A20, 161
- Solar Technology. Ullmann's Encyclopedia. 1993, vol. A24, 369